# EUROPEAN PATENT SPECIFICATION

(11) **EP 4 120 477 B1**
(45) Date of publication and mention of the grant of the patent: **04.03.2026**
(21) Application number: 21306005.6
(22) Date of filing: 16.07.2021
(51) Int. Cl.: H04B 5/28, H01Q 13/20

(54) **ANTENNA MODULE FOR WIRELESS ELECTROMAGNETIC WAVE COMMUNICATION INSIDE AN ELECTRICAL CABINET, LEAKY WAVE ANTENNA COMPRISING A PLURALITY OF ANTENNA MODULES, AND SWITCHGEAR INSTALLATION COMPRISING SUCH LEAKY WAVE ANTENNA**
ANTENNENMODUL FÜR DRAHTLOSKOMMUNIKATION ÜBER ELEKTROMAGNETISCHE WELLEN INNERHALB EINES SCHALTSCHRANKS, LECKWELLENANTENNE MIT MEHREREN ANTENNENMODULEN UND SCHALTANLAGE MIT SOLCH EINER LECKWELLENANTENNE
MODULE D'ANTENNE POUR LA COMMUNICATION SANS FIL PAR ONDES ÉLECTROMAGNÉTIQUES À L'INTÉRIEUR D'UNE ARMOIRE ÉLECTRIQUE, ANTENNE À ONDE DE FUITE COMPRENANT UNE PLURALITÉ DE MODULES D'ANTENNE ET INSTALLATION DE COMMUTATION COMPRENANT UNE TELLE ANTENNE À ONDE DE FUITE

(43) Date of publication of application: 18.01.2023
(73) Proprietor: Schneider Electric Industries SAS, 92500 Rueil-Malmaison (FR)
(72) Inventor: NIEMBRO, Alejandro, 38000 GRENOBLE (FR); BERTHOUD, Yoann, 38000 GRENOBLE (FR); DREINA, Emmanuel, 38240 MEYLAN (FR)
(74) Representative: Lavoix

(56) References cited:
- WO-A1-2019/167333
- GEISE R. ET AL: "A reconfigurable antenna construction toolkit with modular slotted waveguide elements for arbitrary pattern designs", 3 November 2016 (2016-11-03), pages 1 - 6, XP055875387, Retrieved from the Internet <URL:https://ieeexplore.ieee.org/stampPDF/getPDF.jsp?tp=&arnumber=7806292&ref=aHR0cHM6Ly9pZWVleHBsb3JlLmllZWUub3JnL2RvY3VtZW50Lzc4MDYyOTI=> [retrieved on 20211221], DOI: 10.1109/AMTAP.2016.7806292

## Description

The present invention relates to a leaky wave antenna comprising a plurality of antenna modules, and to a switchgear installation comprising such a leaky wave antenna.

In the field of power systems, it is known to use electrical cabinets, indicated also as electric switchgear or switchboards, which can be used individually or as units of more complex electrical installations formed by a plurality of electrical cabinets.

In particular, each electrical cabinet comprises a metallic enclosure having typically a parallelepiped structure, and a whole electrical installation is usually realized according to a modular configuration where a desired number of cabinets is used, with the various electrical cabinets being placed side by side, one adjacent to the other and all substantially aligned along a row.

Inside the enclosure of each cabinet there are installed various types of equipment which are needed for performing the operative tasks assigned to each cabinet individually and to the electrical installation as a whole, such as for monitoring and when necessary breaking the power distributed to connected loads, for disconnecting parts of an associated electrical line, for performing local or remote controls, for carrying out metering, diagnostic, et cetera.

Nowadays, more and more devices installed inside electrical cabinets are provided with wired and/or wireless communication capabilities in order to exchange data and operate in coordination with other devices positioned inside the same or in another cabinet of the installation, or with devices outside the installation, e.g. with a higher-level remote or supervising control unit.

To this end, although known solutions allow performing, in a fairly adequate manner, communications among the various devices, and in particular to realize inter-enclosure communications, they present still some drawbacks and technical inconveniences susceptible of further improvements and optimization.

For example, some devices installed inside electrical cabinets may be provided voluntarily with a limited wave emission power to avoid, or at least minimize, electromagnetic compatibility problems, and thus they have a reduced communication range.

Moreover, the presence of many metallic surfaces, be them partitions internal to each cabinet or the external walls of the enclosure, tends to inhibit the proper propagation of the electromagnetic waves and may negatively affect the efficacy and quality of intra- and especially inter-enclosure communications; indeed, a certain part of the incident electromagnetic power is lost across metallic surfaces, and thus the potential communication range can be further reduced.

One known solution adopted to mitigate such negative effects foresees the use of a gateway, namely a transmitter/receiver unit, in as many as necessary cabinets to boost the strength of the communication waves.

However, this solution increases complexity and costs due to the additional units needed.

WO 2019/167333 A1 discloses a wireless communication system which comprises a shield chamber forming part, a leakage waveguide, a first antenna, a first device, a second antenna, and a second device. In the shield chamber forming part, an internal space serving as a shield chamber is covered with an electromagnetic wave reflector that blocks wireless communications. The leakage waveguide is provided with a first leakage portion and a second leakage portion that are disposed inside the shield chamber forming part. The first antenna is disposed inside the shield chamber forming part and configured to be capable of wireless communication with the first leakage portion. The first device is disposed inside the shield chamber forming part and has the first antenna. The second antenna is disposed inside the shield chamber forming part and is capable of wireless communication with the second leakage portion. The second device is disposed inside the shield chamber forming part and has the second antenna. The first device and the second device perform direct two-way wireless communications between each other and via the leakage waveguide.

Published article Geise R. et Al. "A reconfigurable antenna construction toolkit with modular slotted waveguide elements for arbitrary pattern designs" discloses a modular slotted waveguide antenna, wherein blinds can be used for partially covering the radiating slots of the radiating modules so as to adjust the amplitude of radiating elements forming the modular waveguide antenna.

It is a main aim of the present invention to provide a new solution capable of mitigating, at least partially, one or more of the previously mentioned drawbacks and technical inconvenient, and in particular allowing to improve, with respect to know solutions, the way communication-related electromagnetic waves are radiated inside each individual electrical cabinet, as well as across a plurality of electrical cabinets.

This aim is achieved by a leaky wave antenna for wireless electromagnetic wave communication across a plurality of electrical cabinets, and by an electrical switchgear installation, as defined in the appended set of claims.

Further characteristics and advantages will become apparent from the description of some preferred but not exclusive exemplary embodiments of an antenna module, a leaky wave antenna, and a switchgear installation according to the present invention, illustrated only by way of non-limitative examples with the accompanying drawings, wherein:
figure 1 is a schematic view illustrating an exemplary electrical cabinet inside which there is installed an antenna module according to the present invention;
figure 2 is a perspective view schematically illustrating a first exemplary embodiment of a waveguide unit which can be used to realize an antenna module used in a leaky wave antenna according to the invention;
figure 3 is a perspective view schematically illustrating a second exemplary embodiment of a waveguide unit which can be used to realize an antenna module used in a leaky wave antenna according to the invention;
figures 4 and 5 are views schematically illustrating a third exemplary embodiment of a waveguide unit which can be used to realize an antenna module used in a leaky wave antenna according to the invention, shown in two different operative positions;
figure 6 is a perspective view schematically illustrating a further exemplary embodiment of a waveguide unit which can be used to realize an antenna module used in a leaky wave antenna according to the invention;
figure 7 is a schematic view illustrating a leaky wave antenna according to the invention, composed of several antenna modules which are mechanically connected to each other according to a possible assembly configuration;
figure 8 is a schematic view illustrating a leaky wave antenna according to the invention, which is composed of several antenna modules operatively associated to each other, and is installed across a plurality of electrical cabinets positioned side by side and aligned in sequence to form a switchgear installation.

It should be noted that in the detailed description that follows, identical or similar components, either from a structural and/or functional point of view, have the same reference numerals, regardless of whether they are shown in different embodiments of the present disclosure; it should also be noted that in order to clearly and concisely describe the present disclosure, the drawings may not necessarily be to scale and certain features of the disclosure may be shown in somewhat schematic form.

Further, when the term "adapted", or "arranged", or "configured", or "shaped", or a similar term is used herein while referring to any component as a whole, or to any part of a component, or to a combination of components, it has to be understood that it means and encompasses correspondingly either the structure, and/or configuration and/or form and/or positioning of the related component or part thereof, or the combination such term refers to.

In addition, when the term "substantial" or "substantially" is used herein, it has to be understood as encompassing an actual variation of plus or minus 5% with respect to an indicated reference axis or position, and when the terms transversal or transversally are hereby used, they have to be understood as encompassing a direction non-parallel to the reference part(s) or direction(s)/axis they refer to, and perpendicularity has to be considered a specific case of transverse direction.

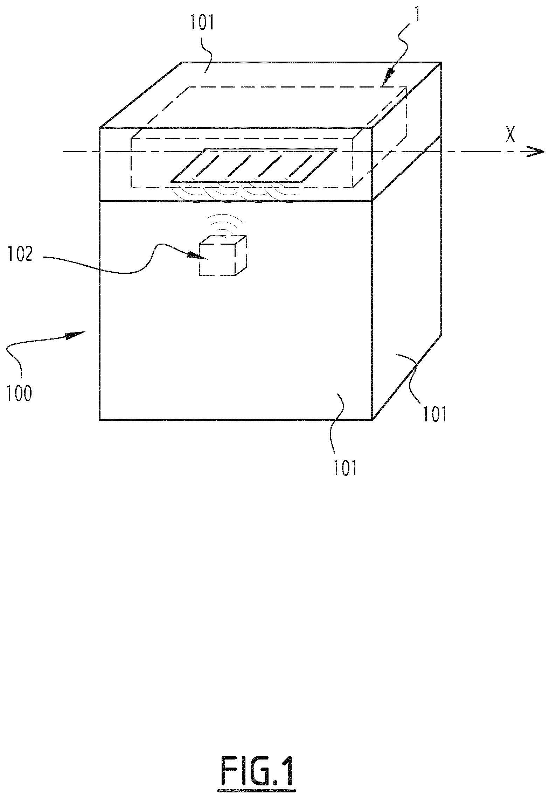

Figure 1 illustrates schematically an electrical cabinet 100 which comprises, according to solutions well known in the art and therefore not described herein in details, an enclosure constructed by or comprising a plurality of side metallic walls 101 which altogether delimit an internal space devised to accommodate one or more devices, such as circuit breakers, relays, electronic control devices, et cetera; in turn, the internal space can be further partitioned by means of internal partitions.

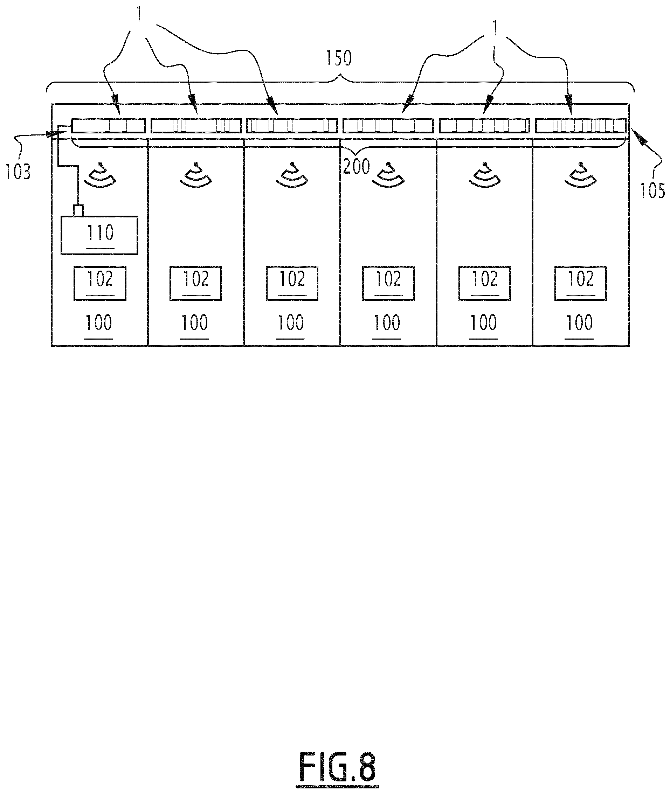

At least one of the devices located inside the enclosure, an exemplary representation of which is schematically illustrated in figure 1 by the reference number 102, is adapted for wireless communication with at least another correspondingly adapted communication device. Such another device can be located inside the same cabinet 100, in another cabinet, such as one of the cabinets 100 of the switchgear installation 150 illustrated in figure 8, or a device remote from any of the cabinets 100 of figures 1 and 8, e.g. a remote control or supervising device.

To this end, according to the invention and as illustrated in the exemplary embodiment of figure 1, an antenna module 1 is installed inside the enclosure of the electrical cabinet 100 and comprises at least one leaky waveguide unit 10 which extends along a reference axis X, i.e. along an axis which extends substantially horizontally across the electrical cabinet 100, and is configured to radiate electromagnetic waves inside the enclosure of the associated electrical cabinet 100.

According to an alternative embodiment not shown in the attached figures, the antenna module 1 can be installed inside the enclosure of the electrical cabinet 100 in a different position, for instance with the leaky waveguide unit 10 extending in a direction substantially perpendicular to the reference axis X, i.e. vertically inside the enclosure.

According to this embodiment, when there is a plurality of cabinets 100 positioned in a row to form a switchgear installation, such as the one illustrated in figure 8, the various cabinets 100 can be equipped each with a corresponding antenna module 1, and the various antenna modules 1, in particular their respective leaky waveguide units 10, can be operatively connected via a waveguide running across the various cabinets, e.g. horizontally, at the base or at a top part of the various units 10.

In particular, the leaky wave unit 10 is adapted to mechanically adjust the power of electromagnetic waves radiated inside the enclosure of the associated electrical cabinet 100.

In practice, as it will result more in details in the following description, the leaky wave unit 10 comprises means for mechanically adjusting the power of electromagnetic waves radiated inside the enclosure; in particular, at least one leaky waveguide unit comprises one or more through-openings each selectively modifiable in location and/or dimensions to adjust the power of electromagnetic waves radiated inside the enclosure.

In one possible embodiment of the antenna module 1, the leaky waveguide unit 10 is further adapted to be operatively coupled with at least one further leaky waveguide unit 10 which is installed in the enclosure of an adjacent electrical cabinet 100.

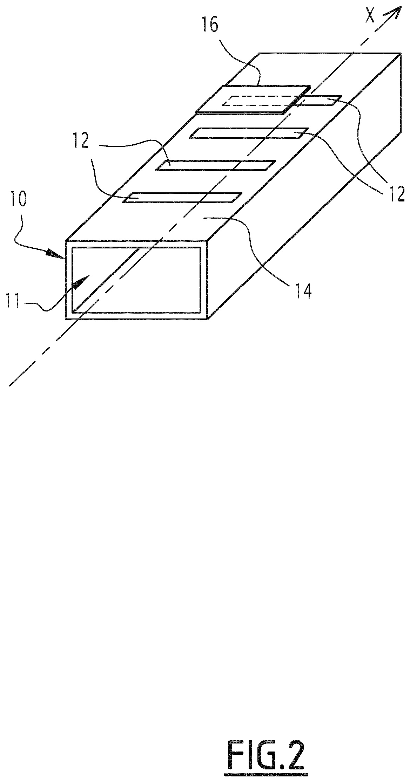

As illustrated in the exemplary embodiments of figures 2 to 6, the leaky waveguide unit 10 comprises a metallic body, made in a single piece or in two or more pieces assembled together, which has for instance a substantially rectangular cross section and is open at one end side 11 and at the opposite end side 13.

The metallic body of the leaky waveguide unit 10 can be an additional part installed inside the enclosure of the cabinet 100, or it can be formed, in part or completely, using parts already existing in the cabinet 100 itself.

Each of the open end sides 11 and 13 is suitable to operatively couple, i.e. at least functionally and in case also mechanically, a leaky waveguide unit 10 with another waveguide unit 10 installed in the same cabinet or in an adjacent electrical cabinet 100, or with a feeding point.

Conveniently, the leaky waveguide unit 10 used in the antenna module 1 according to the invention comprises, as above mentioned, one or more through openings which constitute the leaky radiation points of the antenna module 1 and define a total radiating area potentially available for radiating electromagnetic waves inside the enclosure of the associated electrical cabinet 100.

Depending on the applications, and in particular on the positioning of the leaky waveguide unit 10 relative to the device(s) 102, the through openings, which can have different shapes, extensions and positions, can be provided on any suitable wall of the leaky waveguide unit 10; for instance, in the exemplary embodiment illustrated in figure 1, the through openings are schematically depicted in the lower wall of the leaky waveguide unit 10, while in figures 2 to 6 they are represented as provided on the upper wall 14 merely for the sake of ease of illustration.

Clearly, if necessary the openings can be provided also along any lateral side of the leaky waveguide unit 10.

Usefully, the leaky waveguide unit 10 comprises mechanical means for selectively modifying the available total radiating area formed by the one or more through openings, and/or the position of at least part of the total radiating area available formed by the one or more slots 12.

More in details, according to an exemplary embodiment illustrated in figure 2, the waveguide unit 10 comprises one or more slots 12, preferably a plurality of individual slots 12, which extend transversally with respect to the reference axis X, for instance substantially perpendicular relative thereto, and at least one recloser 16, made of electrically conductive material, which is adapted to at least partially close at least one of the one or more transversal slots 12.

For example, the at least one recloser 16 can be constituted by a metallic plate, suitably sized, which can be applied to the upper wall 14 of the metallic body in order to close a desired portion of an associated slot 12; for instance, the conductive plate 16 can be mounted on the wall 14 slidably movable relative thereto, or it can be applied and fixed in a desired position.

In the exemplary embodiment illustrated in figure 2, for the sake of simplicity there is depicted only one recloser 16 closing partially only one slot 12.

Clearly, depending on the applications, it is possible to use more reclosers 16 each associated to only one slot 12 or to more slots 12 at the same time.

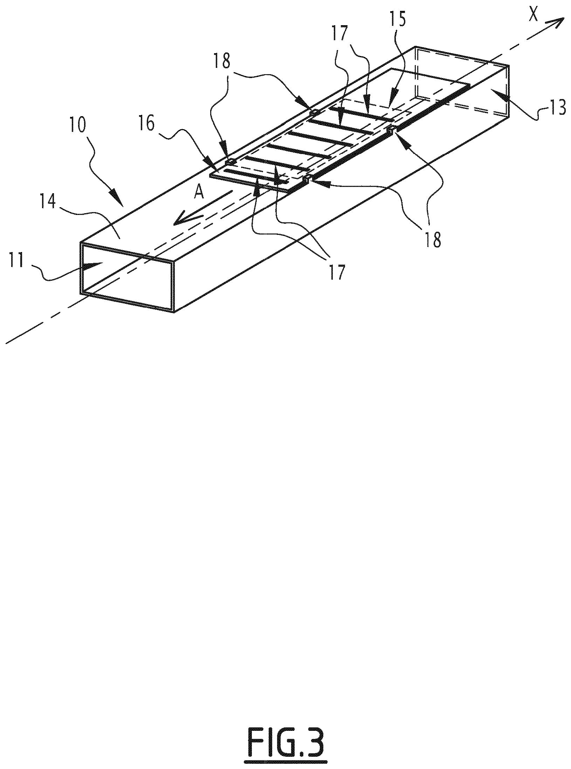

According to another possible embodiment, schematically illustrated in figure 3, the leaky waveguide unit 10 comprises at least one aperture, represented by the dotted box 15, defining an open area which is wider than that of each of the individual slots 12 of the example illustrated in figure 2; such aperture 15 has for example the form of a rectangular or squared window.

Further, according to this embodiment, the leaky waveguide unit 10 comprises at least one electrically conductive recloser 16, e.g. a metallic plate, provided with associated one or more slots 17 extending transversally, e.g. perpendicularly, with respect to the reference axis X.

In particular, the conductive recloser 16 is adapted to be applied at and is movable relative to the aperture 15 for selectively adjusting the number and/or position of its associated one or more transversal slots 17 facing the aperture 15.

In practice, according to this embodiment, the slotted conductive plate 16 is mechanically coupled to the upper wall 14 of the metallic body of the unit 10, for example by inserting its sides in lateral guiding elements 18; thus, the closing plate 16 can slide relative to the wall 14, for example in the direction indicated in figure 3 by the arrow A.

In this way, depending on the applications, it is possible for example to select the desired number of slots 17 still facing the open area of the aperture 15, and thus forming radiating slots, and those slots 17 which instead face the unopened surface of the wall 14 and hence do not contribute to the radiation of electromagnetic waves inside the electrical cabinet 100.

Clearly, according to this embodiment, it would be possible to have two or more separate apertures 15 provided on the wall 14, and to use one single recloser 16 for all of them, or to use a recloser 16 for each aperture 15.

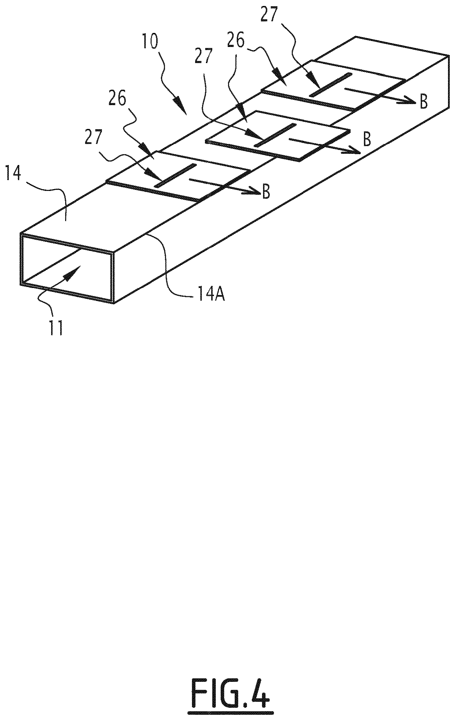

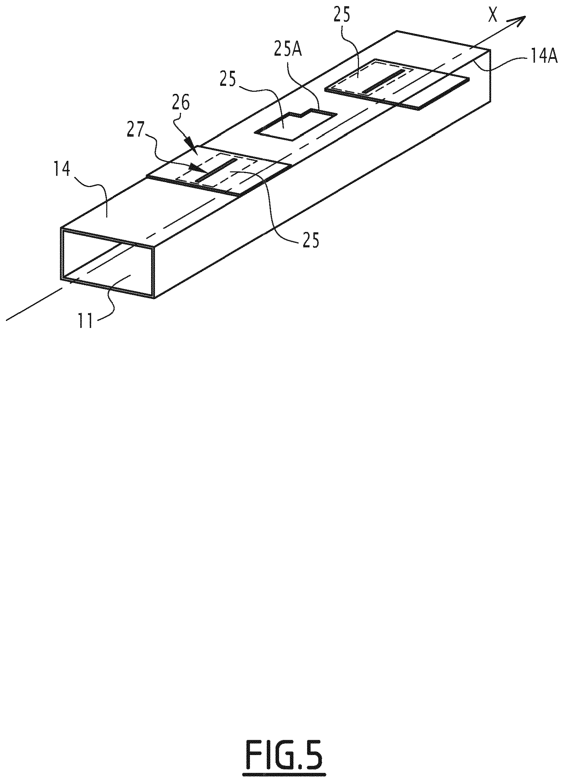

According to another possible embodiment, schematically illustrated in figures 4 and 5, the leaky waveguide unit 10 comprises at least one aperture 25, as visible in figure 5, that is provided on the upper wall 14 of the metallic body of the unit 10 and defines an open area having for example the form of a rectangular or squared window.

Further, according to this embodiment, the leaky waveguide unit 10 comprises at least one electrically conductive recloser 26, e.g. a metallic plate, provided with at least one slot 27 which extends longitudinally, i.e. along a direction substantially parallel to the reference axis X.

The conductive plate 26 is adapted to be applied at and is movable relatively to the associated aperture 25 for selectively adjusting the distance of its at least one slot 27 with respect to a longitudinal edge 14A of the upper wall 14.

In practice, according to this embodiment, the slotted conductive plate 26 is mechanically coupled to the upper wall 14 of the metallic body of the unit 10, in any suitable manner; then, the plate 26 can slide relative to the wall 14, for example in the direction indicated in figure 5 by the arrows B.

In this way, it is possible to selectively adjust the distance of its at least one slot 27 with respect to a longitudinal edge 14A of the first wall itself 14.

The selectable position of the radiating area formed by the open slot 27 facing the aperture 25 allows regulating the power of the electromagnetic waves radiated inside the enclosure; in particular, the radiating power of the electromagnet waves radiated is usefully increased while bringing the slot 27 closer to the longitudinal edge 14A.

Clearly, according to this embodiment, it would be possible to have more longitudinal slots 27 provided on the conductive plate 26, or to have two or more separate apertures 25 provided on the wall 14, as for example illustrated in figure 5 where there are provided three apertures 25.

Further, it is possible to use only one single recloser 26 common to all the apertures 25, or to use a recloser 26 dedicated to each aperture 25, as illustrated in figure 5, where the recloser 26 associated to the central aperture 25 has been removed for rendering this latter directly visible, or different variants of reclosers 26 with various different positions of open slots 27.

According to a possible embodiment, and as illustrated in figure 5, at least one side 25A of an aperture 25 comprises at least one portion which is step-shaped; in this way, when the recloser 16 is applied is possible to modify the resonant frequency of the slot 27.

For the sake of simplicity, the presence of the stepped side 25A is represented in figure 4 only for the central aperture 25, but it can be adopted in any other aperture 25 which may be provided on the wall 14.

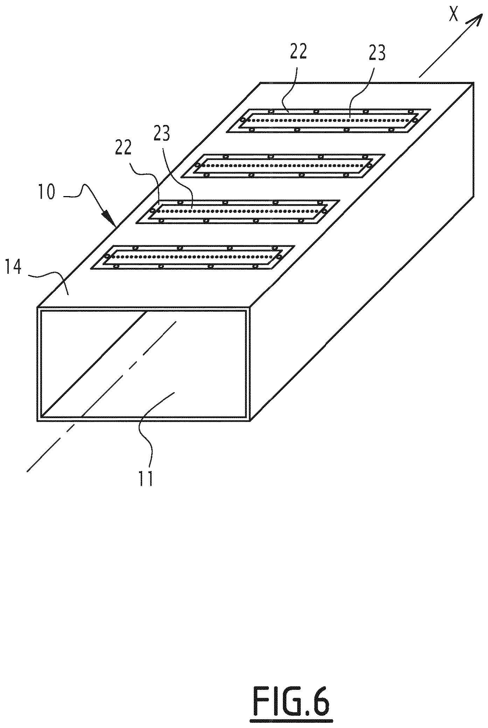

In a further possible embodiment, schematically illustrated in figure 6, the leaky waveguide unit 10 comprises at least a wall, e.g. the upper wall 14, which includes one or more partially pre-cut portions 23 adapted for selectively removing a desired portion of the wall surface to form one or more sizeable slots 22.

For example, such pre-cut portions 23 can comprise cuts or perforations that extend longitudinally and/or transversally with respect to the reference axis X; by definitely cutting and removing any desired portion 23, it is possible to modify the form and/or the extension of any open radiating area formed in the wall, thus modifying for example the length of radiating slots 22.

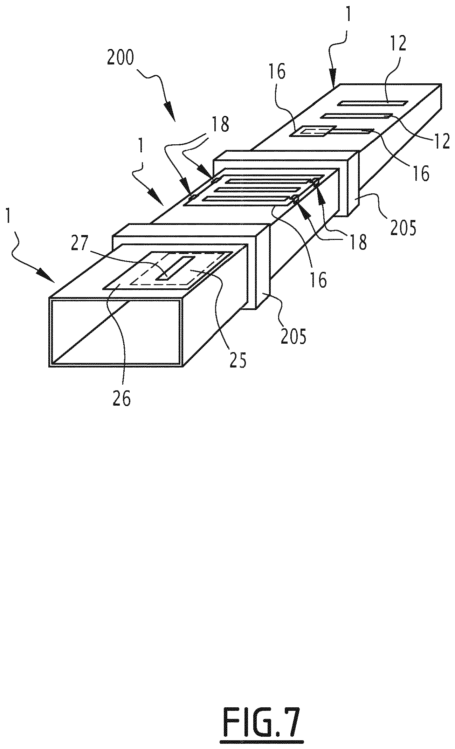

Figure 7 schematically illustrates a leaky wave antenna 200 in accordance with the present invention for wireless electromagnetic wave communication across a plurality of electrical cabinets 100 which are positioned in a row, e.g. in a sequence side by side, as for example illustrated in figure 8 where there are depicted six electrical cabinets 100 of the same or similar type of the cabinet 100 illustrated in figure 1.

The electrical cabinets 100 illustrated in figure 8 form as a whole an electrical installation 150, such as for example a medium voltage switchgear or substation installation.

The leaky wave antenna 200 is configured to be installed across the plurality of electrical cabinets 100 of the installation 150, and has one end 103 connectable to a transmitter/receiver unit, schematically represented in figure 8 by the reference number 110, and is terminated at the other end 105 in a reflection-free manner.

Conveniently, the leaky wave antenna 200 according to the present invention comprises a plurality of antenna modules installed into the enclosure of a respectively associated electrical cabinet 100 of the plurality of electrical cabinets 100, wherein at least one antenna module, preferably the or each antenna module of the plurality of antenna modules comprised in the antenna 200 is an antenna module 1 of a type as previously described and defined by the appended claims.

In particular, in one possible embodiment of the leaky wave antenna 200, at least one of the various antenna modules 1, preferably all antenna modules 1 used, are configured and mutually arranged to radiate electromagnetic waves power each inside the respectively associated electrical cabinet 100, wherein the percentage of available electromagnetic power to be radiated increases progressively along the length of the antenna 200 from an electrical cabinet 100 to an adjacent one, starting from the end 103 of the leaky wave antenna 200 coupled to the transmitter/receiver 110 up to the last electrical cabinet 100 along the row provided with an antenna module 1.

The percentage of available electromagnetic power to be radiated inside each cabinet 100 has to be understood as referring to the initial value of available electromagnetic power entering into each cabinet 100 along the row.

In particular, according to one possible embodiment of the leaky wave antenna 200, at least one antenna module 1, preferably all antenna modules 1 used, are configured and mutually arranged to radiate electromagnetic power each inside the respectively associated electrical cabinet 100 with the radiated power being variable along the length of leaky wave antenna 200 to permit adjustment of electromagnetic wave power distribution.

According to yet another embodiment, the antenna modules 1 are configured and mutually arranged to radiate each substantially the same level of radiated power inside the respectively associated electrical cabinet 100.

In particular, according to a very flexible solution, in order to obtain the desired level of radiating power inside a cabinet 100, and the desired distribution of radiated power along the extension of the leaky wave antenna 200, at least a first antenna module 1 and a second antenna module 1 of the plurality of antenna modules 1 forming the leaky wave antenna 200 are configured differently from each other.

More in particular, according to a possible embodiment all antenna modules 1 forming the leaky wave antenna 200 are configured differently from each other.

To this end, an antenna module 1 can have a configuration different from another antenna module 1 used in the same leaky wave antenna 200, for example in one or more features selected from the group comprising but not limited to:
- the number and/or shape of radiating through openings, be them slots or apertures or any equivalent type of openings provided on a wall of the metallic body of the waveguide unit 10 or on any conductive recloser applied thereto;
- the number and/or configuration of conductive reclosers used;
- the positioning of the through openings, e.g. as transversal, longitudinal or any slant angle slots, which can be positioned closer or further away from any reference edge;
- the mutual spacing of through openings along the extension of the antenna module 1 which can be regularly or irregularly spaced, i.e. all through openings are spaced from each other by the same distance or at least some openings are spaced apart from each other by unequal distances;
- the radiating area defined by each through opening and/or the total radiating area cumulatively defined by all through openings provided by an antenna 1.

For instance, in the exemplary embodiment illustrated in figure 7, the leaky wave antenna 200 comprises three antenna modules 1 differently configured from each other, out of which: a first antenna module 1 is of the type previously described with reference to figure 4 and 5, e.g. with at least one recloser 26 applied to an aperture 25, which is provided with at least one longitudinal slot 27 and is slidable to adjust the distance of the slot 27 relative to the longitudinal edge 14A; a second antenna module 1 is of the type previously described with reference to figure 3; and a third antenna module 1 is of the type previously described with reference to figure 2.

In particular, according to a possible embodiment also illustrated in figure 7, each antenna module 1, suitable to be positioned inside an associated electrical cabinet 100, is mechanically connected with an adjacent antenna module 1, suitable to be installed into an adjacent electrical cabinet 100, via an electrically conductive joint, schematically represented in figure 7 by the reference number 205.

In this way, at least one open end side of each antenna module 1 is mechanically and also functionally coupled with at least one associated open end side of an adjacent antenna module 1, wherein the part of electromagnetic waves travelling inside an antenna module 1, and not radiated inside its associated enclosure, is conveyed into the adjacent antenna module 1 via the respective functionally coupled open end sides.

In one possible embodiment, the electrically conductive joints 205 used to connect two adjacent antenna modules 1 comprise each an elastomeric conductive joint.

Alternatively, according to a further exemplary embodiment schematically illustrated in figure 8, each antenna module 1 of the plurality of antenna modules 1 forming the leaky wave antenna 200 is positioned inside the associated electrical cabinet 100 substantially aligned with an antenna module 1 installed into an adjacent electrical cabinet 100.

In practice, according this configuration, the leaky wave antenna 200 comprises a plurality of antenna modules 1 substantially aligned in sequence and mechanically separated from each other; when installed in the associated electrical cabinet 100, each antenna module 1 has, depending on its position along the sequence, at least one of its open end sides, e.g. the open side 11 and/or the opposite open end side 13, which faces a corresponding open end side of the adjacent antenna module(s) 1.

Thus, also in this configuration, at least one open end side of each antenna module 1 is operatively coupled with at least one associated open end side of an adjacent antenna module 1, wherein the part of electromagnetic waves travelling inside an antenna module 1 not radiated inside its associated enclosure is conveyed into the adjacent antenna module 1 via the respective functionally coupled open end sides.

Hence, it is evident from the foregoing description that the leaky wave antenna 200 and the switchgear installation 150 according to the present invention allow achieving the intended aim since the power needed for proper electromagnetic wave communications can be radiated according to a power level which can be properly adjusted inside a single cabinet, as well as along a row of operatively associated cabinets 100, further up to/from the transmitter/receiver module 110, thus efficiently facing the problem of power loss along the installation.

These results are achieved by the present invention while it is relatively easy to implement and can be realized at competitive costs and is very flexible.

Indeed, as above indicated, the facts that each antenna module 1 can be individually suitably adapted to adjust the radiated power and that the leaky wave antenna 200 has a modular construction, allow to properly modifying and sizing the switchgear installation 150; in fact, when adding or removing a new electrical cabinet 100, the leaky wave antenna 200 can be easily resized by removing the corresponding module or by adding a new one, with the respective radiated power which can be mechanically adjusted in an easy and quick way.

The leaky wave antenna 200 and switchgear installation 150 thus conceived are susceptible of modifications, variations, and on-site calibration according to the needs of the devices inside the relevant electrical cabinet, all of which are within the scope of the inventive concept as defined solely by the appended claims; for example, some of the components illustrated, e.g. the conductive plate forming the recloser 16 or 26 can be differently shaped provided that it remains suitable for the functionalities devised for it within the frame of the present invention; the conductive recloser 16 or 26 can be constituted by or comprise a ribbon or strip of conductive material; the number, or shape or positioning of the slots and/or apertures can vary with respect to the exemplary embodiments depicted in the attached figures; each antenna module 1 can even comprise a combination of the features described in relation to the various embodiments; et cetera.

## Claims

1. A leaky wave antenna (200) for wireless electromagnetic wave communication across a plurality of electrical cabinets (100) positioned in a row, wherein each electrical cabinet (100) comprises:
- an enclosure constructed of metallic partition walls (101); and
- at least one electrical device which is located inside a respective enclosure and is assigned with a communication device for communication with at least one another correspondingly adapted communication device (102) via the leaky wave antenna (200);
the leaky wave antenna (200) being **characterized in that** it has one end connectable to a transmitter/receiver (110) and is terminated at the other end in a reflection-free manner and **in that** it comprises a plurality of antenna modules (1),
wherein each antenna module (1) is installed into the enclosure of a respectively associated electrical cabinet of said plurality of cabinets (100) and comprises at least one leaky waveguide unit (10) which extends along a reference axis (X) and is configured to radiate electromagnetic waves inside the enclosure of the corresponding electrical cabinet (100), the at least one leaky waveguide unit (10) of each antenna module (1) comprising one or more electromagnet wave through-openings each selectively modifiable in location and/or dimensions to adjust the power of electromagnetic waves radiated inside the enclosure of the respectively associated electrical cabinet (100), and wherein
each antenna module (1) is arranged to radiate power inside each respectively associated electrical cabinet with the percentage of available electromagnetic power to be radiated increasing progressively from an electrical cabinet to an adjacent electrical cabinet starting from the end of the leaky wave antenna (100) coupled to the transmitter/receiver (110).

2. The leaky wave antenna (200) according to claim 1, wherein the at least one leaky waveguide unit (10) is adapted to be operatively coupled with another leaky waveguide unit (10) which is installed in the enclosure of the same associated electrical cabinet or of another electrical cabinet adjacent to the same associated electrical cabinet (100).

3. The leaky wave antenna (200) according to claim 1 or 2, wherein the at least one leaky waveguide unit (10) comprises one or more through openings (12, 15, 25) defining a total radiating area available for radiating electromagnetic waves inside the enclosure of the respectively associated electrical cabinet (100), and mechanical means (16, 26, 23) for selectively modifying at least one of the available total radiating area and/or the position of at least part of the total radiating area formed by the one or more through openings.

4. The leaky wave antenna (200) according to claim 3, wherein the at least one leaky waveguide unit (10) comprises one or more slots (12) which extend transversally with respect to said reference axis (X) and at least one electrically conductive recloser (16) adapted to at least partially close at least one of said one or more transversal slots (12).

5. The leaky wave antenna (200) according to claim 3, wherein the at least one leaky waveguide unit (10) comprises at least one aperture (15) and at least one electrically conductive recloser (16) provided with associated one or more slots (17) extending transversally with respect to said reference axis (X), the conductive recloser (16) being adapted to be applied at said aperture (15) and movable relative thereto for selectively adjusting a number and/or position of its associated one or more transversal slots (17) facing the aperture (15).

6. The leaky wave antenna (200) according to claim 3, wherein the at least one leaky waveguide unit (10) comprises a wall (14) on which there is provided an aperture (25), and at least one electrically conductive recloser (26) provided with at least one associated slot (27) extending longitudinally with respect to said reference axis (X), the conductive recloser (26) being adapted to be applied at and with its at least one associated slot (27) facing said aperture (25), and wherein the conductive recloser (27) is movable relative to said first wall (14) to selectively adjust the distance of its at least one associated slot with respect to a longitudinal edge (14A) of the first wall itself (14).

7. The leaky wave antenna (200) according to claim 6, wherein one side (25A) of said aperture (25) comprises at least one portion which is shaped to enable selective adjustment of the length of the through opening of the associated slot (27).

8. The leaky wave antenna (200) according to claim 7, wherein the shape to enable selective adjustment of the length of the through opening of the associated slot (27) is a step-shape.

9. The leaky wave antenna (200) according to claim 3, wherein the at least one leaky waveguide unit (10) comprises at least a wall (14) including one or more partially pre-cut areas (23) adapted each for selectively removing a desired portion of the wall surface to form one or more sizeable slots (22).

10. The leaky wave antenna (200) according to claim 1, wherein the plurality of antenna modules (1) comprises at least a first antenna module (1) and a second antenna module (1) which are installed each into the enclosure of a respectively associated electrical cabinet (100) and are configured differently from each other.

11. The leaky wave antenna (200) according to claim 1 or 10, wherein all antenna modules (1) of said plurality of antenna modules (1) are configured differently from each other.

12. The leaky wave antenna (200) according to one or more of claims 10 to 11, wherein each antenna module (1) of the plurality of antenna modules (1) is arranged to radiate power each inside the respectively associated electrical cabinet with the percentage of radiated power being variable along the length of leaky wave antenna (100) to permit adjustment of electromagnetic wave power distribution.

13. The leaky wave antenna (200) according to one or more of the claims 10 to 12, wherein the antenna modules (1) of the plurality of antenna modules (1)are mutually arranged to radiate each substantially the same level of power inside the respectively associated electrical cabinet (100).

14. The leaky wave antenna (200) according to one or more of the claims 10 to 13,
wherein each antenna module (1) of the plurality of antenna modules (1) is positioned inside an associated electrical cabinet (100) facing to and mechanically separated from an adjacent antenna module (1) installed into an adjacent electrical cabinet (100).

15. The leaky wave antenna (200) according to one or more of the claims 10 to 14, whereineach antenna module (1) of the plurality of antenna modules (1) is positioned inside the respectively associated electrical cabinet (100) and is mechanically connected with an adjacent antenna module (1) installed into an adjacent electrical cabinet (100) via an electrically conductive joint (205).

16. The leaky wave antenna (200) according to claims 15, wherein the electrically conductive joint (205) comprises an elastomeric conductive joint.

17. An electrical switchgear installation comprising a plurality of electrical cabinets positioned in sequence side by side, **characterized in that** it comprises a leaky wave antenna (100) according to one or more of the preceding claims.

## Patentansprüche

1. Leckwellenantenne (200) für drahtlose elektromagnetische Wellenkommunikation über eine Vielzahl von in einer Reihe angeordneten Schaltschränken (100), wobei jeder Schaltschrank (100) Folgendes umfasst:
- ein Gehäuse, das aus metallischen Trennwänden (101) gebaut ist, und
- mindestens eine elektrische Vorrichtung, die sich innerhalb eines jeweiligen Gehäuses befindet und der eine Kommunikationseinrichtung zur Kommunikation mit mindestens einer anderen entsprechend angepassten Kommunikationsvorrichtung (102) über die Leckwellenantenne (200) zugewiesen ist;
wobei die Leckwellenantenne (200) **dadurch gekennzeichnet ist, dass** sie mit einem Ende an einen Sender/Empfänger (110) anschließbar ist und an dem anderen Ende auf reflexionsfreie Weise abgeschlossen ist und dass sie mehrere Antennenmodule (1) umfasst,
wobei jedes Antennenmodul (1) in dem Gehäuse eines jeweils zugeordneten Schaltschranks der Vielzahl von Schränken (100) installiert ist und mindestens eine Leckwellenleitereinheit (10) umfasst, die sich entlang einer Bezugsachse (X) erstreckt und konfiguriert ist, um elektromagnetische Wellen innerhalb des Gehäuses des entsprechenden Schaltschranks (100) abzustrahlen, die mindestens eine Leckwellenleitereinheit (10) von jedem Antennenmodul (1) umfassend eine oder mehrere elektromagnetische Wellendurchgangsöffnungen, die jeweils selektiv in ihrer Lage und/oder ihren Abmessungen modifizierbar sind, um die Leistung der elektromagnetischen Wellen einzustellen, die innerhalb des Gehäuses des jeweils zugewiesenen Schaltschranks (100) abgestrahlt werden, und wobei
jedes Antennenmodul (1) angeordnet ist, um Leistung innerhalb von jedem jeweils zugewiesenen Schaltschrank abzustrahlen, wobei der Prozentsatz der verfügbaren elektromagnetischen Leistung, die abgestrahlt werden soll, von einem Schaltschrank zu einem benachbarten Schaltschrank beginnend mit dem Ende der Leckwellenantenne (100), die mit dem Sender/Empfänger (110) gekoppelt ist, progressiv zunimmt.

2. Leckwellenantenne (200) nach Anspruch 1, wobei die mindestens eine Leckwellenleitereinheit (10) angepasst ist, um mit einer anderen Leckwellenleitereinheit (10), die im Gehäuse desselben assoziierten Schaltschranks oder eines anderen Schaltschranks, der an denselben assoziierten Schaltschrank (100) angrenzt, installiert ist, funktionsfähig gekoppelt zu werden.

3. Leckwellenantenne (200) nach Anspruch 1 oder 2, wobei die mindestens eine Leckwellenleitereinheit (10) eine oder mehrere Durchgangsöffnungen (12, 15, 25), die eine Gesamtabstrahlungsfläche definieren, die für die Abstrahlung elektromagnetischer Wellen innerhalb des Gehäuses des jeweils assoziierten Schaltschranks (100) zur Verfügung steht, und mechanische Einrichtungen (16, 26, 23) zum selektiven Modifizieren mindestens einer der verfügbaren Gesamtabstrahlungsflächen und/oder der Position mindestens eines Teils der durch die eine oder mehreren Durchgangsöffnungen gebildeten Gesamtabstrahlungsfläche umfasst.

4. Leckwellenantenne (200) nach Anspruch 3, wobei die mindestens eine Leckwellenleitereinheit (10) einen oder mehrere Schlitze (12), die sich quer zur Bezugsachse (X) erstrecken, und mindestens einen elektrisch leitenden Wiederverschluss (16) umfasst, der angepasst ist, um mindestens einen von dem einen oder den mehreren transversalen Schlitzen (12) zumindest teilweise zu verschließen.

5. Leckwellenantenne (200) nach Anspruch 3, wobei die mindestens eine Leckwellenleitereinheit (10) mindestens eine Öffnung (15) und mindestens einen elektrisch leitenden Wiederverschluss (16) umfasst, der mit einem oder mehreren assoziierten Schlitzen (17) versehen ist, die sich quer zu der Bezugsachse (X) erstrecken, wobei der leitende Wiederverschluss (16) angepasst ist, um an der Öffnung (15) angebracht zu werden und in Bezug darauf beweglich zu sein, um eine Anzahl und/oder Position seines assoziierten einen oder mehrerer transversaler Schlitze (17), die der Öffnung (15) gegenüberliegen, selektiv einzustellen.

6. Leckwellenantenne (200) nach Anspruch 3, wobei die mindestens eine Leckwellenleitereinheit (10) eine Wand (14), an der eine Öffnung (25) bereitgestellt ist, und mindestens einen elektrisch leitenden Wiederverschluss (26) umfasst, der mit mindestens einem assoziierten Schlitz (27) versehen ist, der sich in Bezug auf die Bezugsachse (X) in Längsrichtung erstreckt, wobei der leitende Wiederverschluss (26) angepasst ist, um an und mit seinem mindestens einen zugehörigen Schlitz (27) der Öffnung (25) zugewandt angebracht zu werden, und wobei der leitende Wiederverschluss (27) in Bezug auf die erste Wand (14) beweglich ist, um den Abstand seines mindestens einen assoziierten Schlitzes in Bezug auf einen Längsrand (14A) der ersten Wand an sich (14) selektiv einzustellen.

7. Leckwellenantenne (200) nach Anspruch 6, wobei eine Seite (25A) der Öffnung (25) mindestens einen Abschnitt umfasst, der geformt ist, um eine selektive Einstellung der Länge der Durchgangsöffnung des assoziierten Schlitzes (27) zu ermöglichen.

8. Leckwellenantenne (200) nach Anspruch 7, wobei die Form, die eine selektive Einstellung der Länge der Durchgangsöffnung des assoziierten Schlitzes (27) ermöglicht, eine Stufenform ist.

9. Leckwellenantenne (200) nach Anspruch 3, wobei die mindestens eine Leckwellenleitereinheit (10) mindestens eine Wand (14) mit einem oder mehreren teilweise vorgeschnittenen Bereichen (23) umfasst, die jeweils zum selektiven Entfernen eines gewünschten Abschnitts der Wandoberfläche geeignet sind, um einen oder mehrere größenveränderbare Schlitze (22) zu bilden.

10. Leckwellenantenne (200) nach Anspruch 1, wobei die Vielzahl von Antennenmodulen (1) mindestens ein erstes Antennenmodul (1) und ein zweites Antennenmodul (1) umfasst, die jeweils in das Gehäuse eines jeweils assoziierten Schaltschranks (100) installiert und unterschiedlich konfiguriert sind.

11. Leckwellenantenne (200) nach Anspruch 1 oder 10, wobei alle Antennenmodule (1) der Vielzahl von Antennenmodulen (1) unterschiedlich konfiguriert sind.

12. Leckwellenantenne (200) nach einem oder mehreren der Ansprüche 10 bis 11, wobei jedes Antennenmodul (1) der Vielzahl von Antennenmodulen (1) angeordnet ist, um Leistung innerhalb des jeweils assoziierten Schaltschranks abzustrahlen, wobei der Prozentsatz der abgestrahlten Leistung entlang der Länge der Leckwellenantenne (100) variabel ist, um eine Einstellung der Leistungsverteilung der elektromagnetischen Wellen zu ermöglichen.

13. Leckwellenantenne (200) nach einem oder mehreren der Ansprüche 10 bis 12, wobei die Antennenmodule (1) der Vielzahl von Antennenmodulen (1) angeordnet sind, um jeweils im Wesentlichen die gleiche Leistung innerhalb des jeweils assoziierten Schaltschranks (100) abzustrahlen.

14. Leckwellenantenne (200) nach einem oder mehreren der Ansprüche 10 bis 13,
wobei jedes Antennenmodul (1) der Vielzahl von Antennenmodulen (1) innerhalb eines assoziierten Schaltschranks (100) positioniert ist, der einem benachbarten Antennenmodul (1), das in einem benachbarten Schaltschrank (100) installiert ist, gegenüberliegt und mechanisch davon getrennt ist.

15. Leckwellenantenne (200) nach einem oder mehreren der Ansprüche 10 bis 14, wobei jedes Antennenmodul (1) der Vielzahl von Antennenmodulen (1) innerhalb des jeweils assoziierten Schaltschranks (100) angeordnet und mit einem benachbarten, in einem angrenzenden Schaltschrank (100) installierten Antennenmodul (1) über eine elektrisch leitende Verbindung (205) mechanisch verbunden ist.

16. Leckwellenantenne (200) nach Anspruch 15, wobei die elektrisch leitende Verbindung (205) eine leitende Elastomerverbindung umfasst.

17. Elektrische Schaltanlage, umfassend eine Vielzahl von Schaltschränken, die aufeinanderfolgend nebeneinander angeordnet sind, **dadurch gekennzeichnet, dass** sie eine Leckwellenantenne (100) nach einem oder mehreren der vorherigen Ansprüche umfasst.

## Revendications

1. Antenne à ondes de fuite (200) pour la communication sans fil d'ondes électromagnétiques à travers une pluralité d'armoires électriques (100) positionnées dans une rangée, dans laquelle chaque armoire électrique (100) comprend :
- une enceinte constituée de cloisons métalliques (101) ; et
- au moins un dispositif électrique situé à l'intérieur d'une enceinte respective et doté d'un dispositif de communication pour communiquer avec au moins un autre dispositif de communication adapté (102) via l'antenne à ondes de fuite (200) ;
l'antenne à ondes de fuite (200) est **caractérisée en ce qu'**elle présente une extrémité pouvant être connectée à un émetteur/récepteur (110) et est terminée à l'autre extrémité de manière à éviter toute réflexion, et **en ce qu'**elle comprend plusieurs modules d'antenne (1),
dans lequel chaque module d'antenne (1) est installé dans l'enceinte d'une armoire électrique respectivement associée à ladite pluralité d'armoires (100) et comprend au moins une unité de guide d'ondes de fuite (10) qui s'étend le long d'un axe de référence (X) et est configurée pour émettre des ondes électromagnétiques à l'intérieur de l'enceinte de l'armoire électrique correspondante (100), l'au moins une unité de guide d'ondes de fuite (10) de chaque module d'antenne (1) comprend une ou plusieurs ouvertures de passage d'ondes électromagnétiques dont l'emplacement et/ou les dimensions peuvent être modifiés sélectivement pour ajuster la puissance des ondes électromagnétiques rayonnées à l'intérieur de l'enceinte de l'armoire électrique correspondante (100), et dans lequel
chaque module d'antenne (1) est conçu pour émettre de la puissance à l'intérieur de chaque armoire électrique associée, le pourcentage de puissance électromagnétique disponible à émettre augmentant progressivement d'une armoire électrique à une armoire électrique adjacente à partir de l'extrémité de l'antenne à ondes de fuite (100) couplée à l'émetteur/récepteur (110).

2. Antenne à ondes de fuite (200) selon la revendication 1, dans laquelle l'au moins une unité de guide d'ondes de fuite (10) est adaptée pour être couplée de manière opérationnelle à une autre unité de guide d'ondes de fuite (10) qui est installée dans l'enceinte de la même armoire électrique associée ou d'une autre armoire électrique adjacente à la même armoire électrique associée (100).

3. Antenne à ondes de fuite (200) selon la revendication 1 ou 2, dans laquelle au moins une unité de guide d'ondes de fuite (10) comprend une ou plusieurs ouvertures traversantes (12, 15, 25) définissant une surface de rayonnement totale disponible pour le rayonnement d'ondes électromagnétiques à l'intérieur de l'enceinte de l'armoire électrique associée (100), et des moyens mécaniques (16, 26, 23) pour modifier sélectivement au moins l'une de la surface de rayonnement totale disponible et/ou la position d'au moins une partie de la surface de rayonnement totale formée par l'une ou plusieurs des ouvertures traversantes.

4. Antenne à ondes de fuite (200) selon la revendication 3, dans laquelle au moins une unité de guide d'ondes de fuite (10) comprend une ou plusieurs fentes (12) qui s'étendent transversalement par rapport audit axe de référence (X) et au moins un réenclencheur (16) électriquement conducteur adapté pour fermer au moins partiellement au moins l'une desdites fentes transversales (12).

5. Antenne à ondes de fuite (200) selon la revendication 3, dans laquelle l'au moins une unité de guide d'ondes de fuite (10) comprend au moins une ouverture (15) et au moins un réenclencheur électriquement conducteur (16) pourvu d'une ou plusieurs fentes associées (17) s'étendant transversalement par rapport à l'axe de référence (X), le réenclencheur conducteur (16) étant adapté pour être appliqué à ladite ouverture (15) et déplacé par rapport à celle-ci pour ajuster sélectivement un nombre et/ou une position de ses fentes transversales associées (17) faisant face à l'ouverture (15).

6. Antenne à ondes de fuite (200) selon la revendication 3, dans laquelle l'au moins une unité de guide d'ondes de fuite (10) comprend une paroi (14) sur laquelle se trouve une ouverture (25), et au moins un réenclencheur électriquement conducteur (26) pourvu d'au moins une fente associée (27) s'étendant longitudinalement par rapport à l'axe de référence (X), le réenclencheur conducteur (26) étant adapté pour être appliqué sur et avec sa au moins une fente associée (27) face à ladite ouverture (25), et dans lequel le réenclencheur conducteur (27) est mobile par rapport à ladite première paroi (14) afin d'ajuster sélectivement la distance de sa au moins une fente associée par rapport à un bord longitudinal (14A) de la première paroi elle-même (14).

7. Antenne à ondes de fuite (200) selon la revendication 6, dans laquelle un côté (25A) de ladite ouverture (25) comprend au moins une partie qui est formée pour permettre un ajustement sélectif de la longueur de l'ouverture traversante de la fente associée (27).

8. Antenne à ondes de fuite (200) selon la revendication 7, dans laquelle la forme permettant le réglage sélectif de la longueur de l'ouverture traversante de la fente associée (27) est une forme en escalier.

9. Antenne à ondes de fuite (200) selon la revendication 3, dans laquelle au moins une unité de guide d'ondes de fuite (10) comprend au moins une paroi (14) comprenant une ou plusieurs zones partiellement prédécoupées (23) adaptées chacune pour enlever sélectivement une partie souhaitée de la surface de la paroi afin de former une ou plusieurs fentes dimensionnables (22).

10. Antenne à ondes de fuite (200) selon la revendication 1, dans laquelle la pluralité de modules d'antenne (1) comprend au moins un premier module d'antenne (1) et un second module d'antenne (1) qui sont installés chacun dans le boîtier d'une armoire électrique associée (100) et sont configurés différemment l'un de l'autre.

11. Antenne à ondes de fuite (200) selon la revendication 1 ou 10, dans laquelle tous les modules d'antenne (1) de ladite pluralité de modules d'antenne (1) sont configurés différemment les uns des autres.

12. Antenne à ondes de fuite (200) selon une ou plusieurs des revendications 10 à 11, dans laquelle chaque module d'antenne (1) de la pluralité de modules d'antenne (1) est conçu pour rayonner de la puissance à l'intérieur de l'armoire électrique associée, le pourcentage de puissance rayonnée étant variable sur la longueur de l'antenne à ondes de fuite (100) afin de permettre le réglage de la distribution de la puissance des ondes électromagnétiques.

13. Antenne à ondes de fuite (200) selon une ou plusieurs des revendications 10 à 12, dans laquelle les modules d'antenne (1) de la pluralité de modules d'antenne (1) sont réciproquement disposés pour rayonner chacun sensiblement le même niveau de puissance à l'intérieur de l'armoire électrique respectivement associée (100).

14. Antenne à ondes de fuite (200) selon une ou plusieurs des revendications 10 à 13,
dans laquelle chaque module d'antenne (1) de la pluralité de modules d'antenne (1) est positionné à l'intérieur d'une armoire électrique associée (100) faisant face à un module d'antenne adjacent (1) installé dans une armoire électrique adjacente (100) et séparé mécaniquement de ce dernier.

15. Antenne à ondes de fuite (200) selon une ou plusieurs des revendications 10 à 14, dans laquelle chaque module d'antenne (1) de la pluralité de modules d'antenne (1) est positionné à l'intérieur de l'armoire électrique respectivement associée (100) et est mécaniquement connecté à un module d'antenne adjacent (1) installé dans une armoire électrique adjacente (100) par l'intermédiaire d'une jonction électriquement conductrice (205).

16. Antenne à ondes de fuite (200) selon la revendication 15, dans laquelle le joint électriquement conducteur (205) comprend un joint conducteur élastomère.

17. Installation de commutation électrique comprenant plusieurs armoires électriques positionnées en séquence côte à côte, **caractérisée en ce qu'**elle comprend une antenne à ondes de fuite (100) selon l'une ou plusieurs des revendications précédentes.
